(19) Europäisches Patentamt
European Patent Office
Office européen des brevets

(11) **EP 2 447 235 A1**

(12) **EUROPÄISCHE PATENTANMELDUNG**

(43) Veröffentlichungstag:
**02.05.2012 Patentblatt 2012/18**

(21) Anmeldenummer: **11008249.2**

(22) Anmeldetag: **13.10.2011**

(51) Int Cl.:
*C04B 37/00* (2006.01)          *C04B 37/02* (2006.01)
*C04B 41/51* (2006.01)          *H05K 3/38* (2006.01)
*H01L 23/373* (2006.01)

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**

(30) Priorität: **27.10.2010 DE 102010049499**

(71) Anmelder: **Curamik Electronics GmbH**
**92676 Eschenbach (DE)**

(72) Erfinder:
• MEYER, Andreas Dipl.-Ing.
  93173 Wenzenbach (DE)
• SCHULZ-HARDER, Jürgen Dr.
  91207 Lauf (DE)

(74) Vertreter: **Graf Glück Habersack Kritzenberger**
**Hermann-Köhl-Straße 2a**
**93049 Regensburg (DE)**

(54) **Metall-Keramik-Substrat sowie Verfahren zum Herstellen eines solchen Substrates**

(57) Metall-Keramik-Substrat, insbesondere Substrat für elektrische Schaltkreise oder Module mit wenigstens einer eine erste Oberflächenseite des Metall-Keramik-Substrates bildenden Metallschicht und mit wenigstens einer eine zweite Oberflächenseite des Metall-Keramik-Substrates bildenden Metallschicht, wobei diese äußeren Metallschichten jeweils durch Bonden flächig mit den Oberflächenseiten eines plattenförmigen Substratkörpers verbunden sind.

Fig. 1

**Beschreibung**

Die Erfindung bezieht sich auf ein Metall-Keramik-Substrat gemäß Oberbegriff Patentanspruch 1 sowie auf ein Verfahren zum Herstellen eines solchen Substrates gemäß Oberbegriff Patentanspruch 14.

Metall-Keramik-Substrate insbesondere auch solche für elektrische und elektronische Schaltkreise oder -module, d.h. insbesondere als Leiterplatten für derartige Schaltkreise oder Module sind in unterschiedlichen Ausführungen bekannt.

Bekannt ist weiterhin das sogenannten "DCB-Verfahren" (Direct-Copper-Bond-Technology), welches nachstehend auch als DCB-Bonden bezeichnet wird und beispielsweise zum Verbinden von Metallschichten oder -blechen (z.B. Kupferblechen oder -folien) mit einander und/oder mit Keramik oder Keramikschichten dient, und zwar unter Verwendung von Metall- bzw. Kupferblechen oder Metall- bzw. Kupferfolien, die an ihren Oberflächenseiten eine Schicht oder einen Überzug (Aufschmelzschicht) aus einer chemischen Verbindung aus dem Metall und einem reaktiven Gas , bevorzugt Sauerstoff aufweisen. Bei diesem beispielsweise in der US-PS 37 44 120 oder in der DE-PS 23 19 854 beschriebenen Verfahren bildet diese Schicht oder dieser Überzug (Aufschmelzschicht) ein Eutektikum mit einer Schmelztemperatur unter der Schmelztemperatur des Metalls (z.B. Kupfers), so dass durch Auflegen der Folie auf die Keramik und durch Erhitzen sämtlicher Schichten diese miteinander verbunden werden können, und zwar durch Aufschmelzen des Metalls bzw. Kupfers im wesentlichen nur im Bereich der Aufschmelzschicht bzw. Oxidschicht.

Dieses DCB-Verfahren weist dann z.B. folgende Verfahrensschritte auf:

Oxidieren einer Kupferfolie derart, dass sich eine gleichmäßige Kupferoxidschicht ergibt; Auflegen des Kupferfolie auf die Keramikschicht; Erhitzen des Verbundes auf eine Prozesstemperatur zwischen etwa 1025 bis 1083°C, z.B. auf ca. 1071°C; Abkühlen auf Raumtemperatur.

Bekannt ist weiterhin das sogenannte Aktivlot-Verfahren (DE 22 13 115; EP-A-153 618) z.B. zum Verbinden von Metallschichten oder Metallfolien, insbesondere auch von Kupferschichten oder Kupferfolien mit Keramikmaterial. Bei diesem Verfahren, welches speziell auch zum Herstellen von Metall-Keramik-Substraten verwendet wird, wird bei einer Temperatur zwischen ca. 800 - 1000°C eine Verbindung zwischen einer Metallfolie, beispielsweise Kupferfolie, und einem Keramiksubstrat, beispielsweise Aluminiumnitrid-Keramik, unter Verwendung eines Hartlots hergestellt, welches zusätzlich zu einer Hauptkomponente, wie Kupfer, Silber und/oder Gold auch ein Aktivmetall enthält. Dieses Aktivmetall, welches beispielsweise wenigstens ein Element der Gruppe Hf, Ti, Zr, Nb, Ce ist, stellt durch chemische Reaktion eine Verbindung zwischen dem Lot und der Keramik her, während die Verbindung zwischen dem Lot und dem Metall eine metallische Hartlöt-Verbindung ist.

"Bonden" bedeutet im Sinne der Erfindung allgemein Verbinden, z.B. DCB-Bonden, Aktivlöten, Hartlöten, Kleben usw.

Der Ausdruck "im Wesentlichen" bedeutet im Sinne der Erfindung Abweichungen von jeweils exakten Wert um +/-10%, bevorzugt um +/- 5% und/oder Abweichungen in Form von für die Funktion unbedeutenden Änderungen.

Aufgabe der Erfindung ist es, ein Metall-Keramik-Substrat aufzuzeigen, welches verbesserte mechanische, thermische und elektrische Eigenschaften aufweist. Zur Lösung dieser Aufgabe ist ein Metall-Keramik-Substrat entsprechend dem Patentanspruch 1 ausgebildet. Ein Verfahren zum Herstellen des Metall-Keramik-Substrates ist Gegenstand des Patentanspruchs 14.

In Weiterbildung der Erfindung ist das Metall-Keramik-Substrat beispielsweise so ausgeführt,

dass es eine einzige Zwischenschicht zwischen den wenigstens zwei Keramikschichten aufweist, wobei sich die Zwischenschicht über die gesamte oder im Wesentlichen über die gesamte der Zwischenschicht benachbarte Oberflächenseite der Keramikschichten erstreckt,

und/oder

dass die Schichtdicke der Zwischenschicht wenigstens gleich der Schichtdicke der äußeren Metallschichten ist,

und/oder

dass die Schichtdicke der Zwischenschicht größer ist als die Schichtdicke der äußeren Metallschicht,

und/oder

dass die Schichtdicke der Zwischenschicht größer ist als die Schichtdicke wenigstens einer der Keramikschichten,

und/oder

dass die Zwischenschicht mehrlagig mit wenigstens zwei inneren Metallschichten und/oder mit wenigstens einer inneren Metallschicht und einer inneren Isolierschicht, beispielsweise mit einer inneren Keramikschicht ausgebildet ist,

und/oder

dass die die mehrlagige Zwischenschicht bildenden inneren Schichten durch Bonden flächig miteinander verbunden sind,

und/oder

dass die Zwischenschicht mit einer inneren, zwischen zwei inneren Metallschichten angeordneten Isolierschicht ausgebildet ist,

und/oder

dass die Zwischenschicht mit wenigstens einer Ausnehmung, vorzugsweise mit wenigstens einer Ausnehmung zur Bildung eines Kanals oder einer Kammer zur Aufnahme von beim Bonden freigesetzten gas- und/oder dampfförmigen und/oder flüssigen Bestandteile, insbesondere auch zur Aufnahme von überschüssigem beim Bonden verwendeten Bondmittel ausgebildet ist,

und/oder

dass die wenigstens eine Ausnehmung vorzugsweise an wenigstens einer Umfangsseite des Metall-Keramik-Substrates offen ist,
und/oder

dass die mehrlagige Zwischenschicht wenigstens zwei innere Metallschichten aufweist, und/oder

dass in wenigstens einer dieser Metallschichten die wenigstens eine Ausnehmung vorgesehen ist,
und/oder

dass die wenigstens eine Ausnehmung bzw. deren Innenraum an einer Seite der wenigstens einen inneren Metallschicht offen ist, an der diese innere Metallschicht flächig mit einer weiteren Schicht zu der mehrlagigen Zwischenschicht verbunden ist,
und/oder

dass die wenigstens eine Ausnehmung bzw. deren Innenraum von der angrenzenden Keramikschicht durch einen aus der inneren Metallschicht gebildeten Boden getrennt ist, und/oder

dass das Metall-Keramik-Substrat eine Bruchfestigkeit aufweist, die größer ist als die Bruchfestigkeit einer einzelnen Keramikschicht, deren Schichtdicke gleich der Summe der Schichtdicken der beiden durch die Zwischenschicht voneinander beabstandeten Keramikschicht ist,
und/oder

dass zumindest die die Zwischenschicht bildenden Metallschichten oder deren Material eine Brinell-Härte kleiner 75, vorzugsweise kleiner 40 aufweisen,
und/oder

dass zumindest die die Zwischenschicht bildenden inneren Metallschichten mit einer Haft- oder Peelfestigkeit größer 10N/mm mit der jeweils angrenzenden Keramikschicht verbunden sind,
und/oder

dass in wenigstens einer der voneinander beabstandeten Keramikschichten zumindest eine Durchkontaktierung vorgesehen ist, die die auf dieser Keramikschicht angeordnete äußere Metallschicht oder einen Metallschichtbereich dieser äußeren Metallschicht mechanisch, thermisch und/oder elektrisch mit einer inneren Metallschicht verbindet, und/oder

dass das Metall-Keramik-Substrat eine Spannungs- oder Durchschlagfestigkeit von wenigstens 18kV/mm aufweist,
und/oder

dass die Keramikschichten solche aus Al2O3, Al2O3 - ZrO2, AlN, Si3N4 oder aus einer Kombination dieser Keramiken sind,
und/oder

dass die Verbindung zwischen den aneinander angrenzenden Schichten durch DCB-Bonden und/oder Aktivlöten und/oder Hartlöten und/oder unter Verwendung eines Klebers, beispielsweise eines Klebers auf Kunststoff- oder Epoxyharz-Basis, z.B. mit Fasern und/oder unter Verwendung eines elektrisch leitenden Klebers hergestellt ist,
wobei die vorgenannten Merkmale jeweils allein oder in beliebiger Kombination verwendet sein können.

Das erfindungsgemäße Metall-Keramik-Substrat weist bei einer bevorzugten Ausführungsform wenigstens zwei durch eine Zwischenschicht voneinander beabstandete Keramikschichten auf, die beispielsweise aus Al2O3, Al2O3 - ZrO2, AlN und/oder Si3N4 bestehen und durch eine Zwischenschicht voneinander beabstandet sind, die wenigstens eine, an beide Keramikschichten angrenzende innere Metallschicht oder aber wenigstens zwei an jeweils eine Keramikschicht angrenzende innere Metallschichten aufweist. Die jeweilige innere Metallschicht ist dabei mit der Keramikschicht so verbunden, dass sich zur Erzielung einer hohen Biege- und Bruchfestigkeit eine Haft- oder Peelfestigkeit zwischen der inneren Metallschicht und der angrenzenden Keramikschicht größer 10N/mm ergibt. Außerdem weist das Metall der inneren Metallschicht zur Vermeidung von Beschädigungen oder Rissbildungen in der jeweils angrenzenden Keramikschicht insbesondere bei Belastungen durch wechselnde Temperaturen eine Brinell-Härte kleiner 75, vorzugsweise eine Brinell-Härte kleiner 40 auf weist.

Das in dieser Form ausgebildete Metall-Keramik-Substrat besitzt dann bevorzugt eine Bruchfestigkeit, die deutlich, zumindest aber um den Faktor 1,5 größer ist als die Bruchfestigkeit einer einzelnen Keramikschicht mit einer Schichtdicke die gleich der Summe der Schichtdicke der beiden voneinander beabstandeten Keramikschichten des erfindungsgemäßen Substrates ist.

Weiterhin weist das erfindungsgemäße Metall-Keramik-Substrat eine elektrische Spannungs- bzw. Durchschlagfestigkeit auf, die wesentlich größer ist, zumindest aber um den Faktor 1,4 größer ist als die Spannungs- oder Durchschlagfestigkeit eines Substrates mit nur einer Keramikschicht, deren Schichtdicke gleich der Summe der Schichtdicke der beiden voneinander beabstandeten Keramikschichten des erfindungsgemäßen Substrates ist. Bei dem erfindungsgemäßen Substrat sind innerhalb der Keramikschichten mit einer Schichtdicke von etwa 0,3 mm elektrische Feldstärken von wenigstens 18 kV/mm möglich, bevor es zu einem elektrischen Durchschlag kommt.

Weiterbildungen, Vorteile und Anwendungsmöglichkeiten der Erfindung ergeben sich auch aus der nachfolgenden Beschreibung von Ausführungsbeispielen und aus den Figuren. Dabei sind alle beschriebenen und/oder bildlich dargestellten Merkmale für sich oder in beliebiger Kombination grundsätzlich Gegenstand der Erfindung, unabhängig von ihrer Zusammenfassung in den Ansprüchen oder deren Rückbeziehung. Auch wird der Inhalt der Ansprüche zu einem Bestandteil der Beschreibung gemacht.

Die Erfindung wird im Folgenden anhand der Figuren an Ausführungsbeispielen näher erläutert. Es zeigen:

Fig. 1 in vereinfachter Schnittdarstellung ein Metall-Keramik-Substrat gemäß der Erfindung;
Fig. 2 und 3 Messanordnungen zur Bestimmung der Bruchfestigkeit des erfindungsgemäßen Metall-Keramik-Substrates bzw. zur Bestimmung der Haft- oder Peelfestigkeit zwischen einer inneren Metallschicht und der angrenzenden Keramikschicht;

Fig. 4-7 jeweils in vereinfachter Schnittdarstellung Metall-Keramik-Substrate unterschiedlicher Ausführungsformen der Erfindung;

Fig. 8 und 9 jeweils in vergrößerter Darstellung Teilschnitte durch weitere Metall-Keramik-Substrate gemäß der Erfindung.

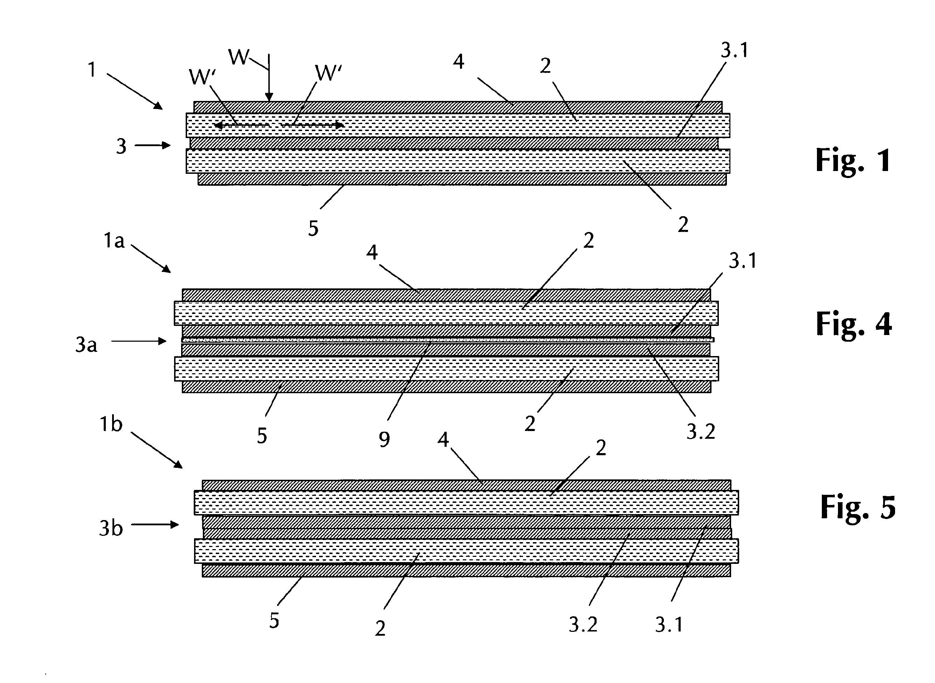

Das in der Figur 1 allgemein mit 1 bezeichnete Metall-Keramik-Substrat mit verbesserten mechanischen, thermischen und elektrischen Eigenschaften besteht im Wesentlichen aus zwei flachen, plattenförmigen Keramikschichten 2, aus einer zwischen diesen Keramikschichten 2 angeordneten und jeweils mit den einander zugewandten Oberflächenseiten der Keramikschicht flächig verbundenen Zwischenschicht 3 in Form einer einzigen inneren Metallschicht 3.1 sowie aus zwei äußeren, auf die einander abgewandten Oberflächenseiten der Keramikschichten 2 aufgebrachten Metallisierungen in Form von Metallschichten 4 und 5. Die Metallschichten 3, 4 und 5 sind bevorzugt Metallfolien und/oder Metallschichten solche aus Kupfer oder einer Kupferlegierung oder aus Aluminium.

Die Keramikschichten 2 bestehen aus einer für Metall-Keramik-Substrate geeigneten Keramik, beispielsweise aus Al2O3, Al2O3 - ZrO2, AlN und/oder Si3N4. Um einen symmetrischen Aufbau des Metall-Keramik-Substrates 1 in Bezug auf eine parallel zu den Oberflächenseiten der Keramikschichten 2 orientierte und in der Mitte zwischen diesen Schichten verlaufende Substratmittelebene zumindest in thermischer Hinsicht zu erreichen und hierdurch einen Bi-Metall-Effekt bei thermischen Belastungen des Metall-Keramik-Substrates 1 zu vermeiden, bestehen die Keramikschichten 2 bei gleicher Schichtdicke d2 bevorzugt aus ein und derselben Keramik. Weiterhin weisen die äußeren Metallschichten 4 und 5, die mit ihren der jeweils benachbarten Keramikschicht 2 abgewandten Oberflächenseiten die Oberseite (Metallschicht 4) bzw. die Unterseite (Metallschicht 5) des Metall-Keramik-Substrates 1 bilden, bevorzugt jeweils die gleiche Dicke d4 bzw. d5 auf (d4 = d5). Grundsätzlich sind aber auch andere Ausführungen denkbar, insbesondere dann, wenn ein zur Substratmittelebene spiegelsymmetrischer Aufbau des Metall-Keramik-Substrates 1 nicht erwünscht und/oder erforderlich ist.

Die Keramikschichten 2 sind mit den Metallschichten 3.1, 4 und 5 bevorzugt unter Verwendung des sogenannten DCB-Verfahrens, d.h. durch DCB-Bonden und/oder durch Aktivlöten verbunden. Die Herstellung erfolgt dabei bevorzugt in einem einzigen Verfahrensschritt, in welchem der aus den beiden Keramikschichten 2, der inneren Metallschicht 3.1 und den beiden äußeren Metallschichten 4 und 5 bestehende Stapel durch DCB-Bonden oder durch Aktivlöten zu dem Metall-Keramik-Substrat 1 verbunden wird. Grundsätzlich kann das Metall-Keramik-Substrat 1 auch in mehreren, zeitlich aufeinander folgenden Verfahrensschritten hergestellt werden, beispielsweise derart, dass in einem ersten Verfahrensschritt jede Keramikschicht 2 nur an einer Oberflächenseite mit der Metallschicht 4 bzw. 5 versehen wird, z.B. durch DCB-Bonden oder Aktivlöten und dass dann in einem weiteren Verfahrensschritt die beiden Keramikschichten 2 an ihrer der Metallschicht 4 bzw. 5 abgewandten Oberflächenseite jeweils mit der mittleren Metallschicht 3.1 zur Anlage gebracht und mit dieser beispielsweise durch DCB-Bonden oder Aktivlöten verbunden werden.

Die beiden Keramikschichten 2 und die innere Metallschicht 3.1 bilden einen Substratkörper mit einer gegenüber der Dicke d4 bzw. d5 der äußeren Metallschichten 4 und 5 wesentlich größeren Dicke, die gleich der Summe aus der zweifachen Dicke d2 der Keramikschichten 2 und der Dicke d3.1 der mittleren Metallschicht 3.1 ist.

Die Schichtdicke d2 jeder Keramikschicht 2 liegt dabei beispielsweise im Bereich zwischen etwa 0,2 bis 1,3 mm. Die Schichtdicke d3.1 der inneren Metallschicht 3 liegt dabei etwa im Bereich zwischen 0,1 bis 0,8 mm und die Schichtdicken d4 und d5 der äußeren Metallschichten 3 und 4 beispielsweise ebenfalls im Bereich von etwa 0,1 bis 0,8 mm. Die Schichtdicken d4 und d5 können hiervon allerdings auch abweichen, und zwar auch abhängig von dem jeweiligen Verwendungszweck des Metall-Keramik-Substrates 1.

Im Verwendungsfall wird zumindest die obere Metallschicht 4 in der dem Fachmann bekannten Weise zur Ausbildung von elektrisch voneinander getrennten Metallschichtbereichen, d.h. zur Ausbildung von elektrischen Kontaktflächen und/oder Leiterbahnen und/oder Anschlüssen usw. strukturiert, beispielsweise durch mechanische Bearbeitung und/oder unter Verwendung der dem Fachmann bekannten Maskierungs- und Ätztechnik.

Durch den in der Figur 1 dargestellten und vorstehend beschriebenen Aufbau weist das Metall-Keramik-Substrat 1 gegenüber herkömmlichen Metall-Keramik-Substraten, die aus einer einzigen Keramikschicht mit beidseitiger Metallisierung bestehen, in überraschender Weise wesentlich verbesserte mechanische, thermische und elektrische Eigenschaften auf. So besitzt das Metall-Keramik-Substrat 1 eine höhere Biegesteifigkeit und eine zumindest um den Faktor 1,5 verbesserte Bruchfestigkeit gegenüber der Bruchfestigkeit einer der Keramikschichten 2.

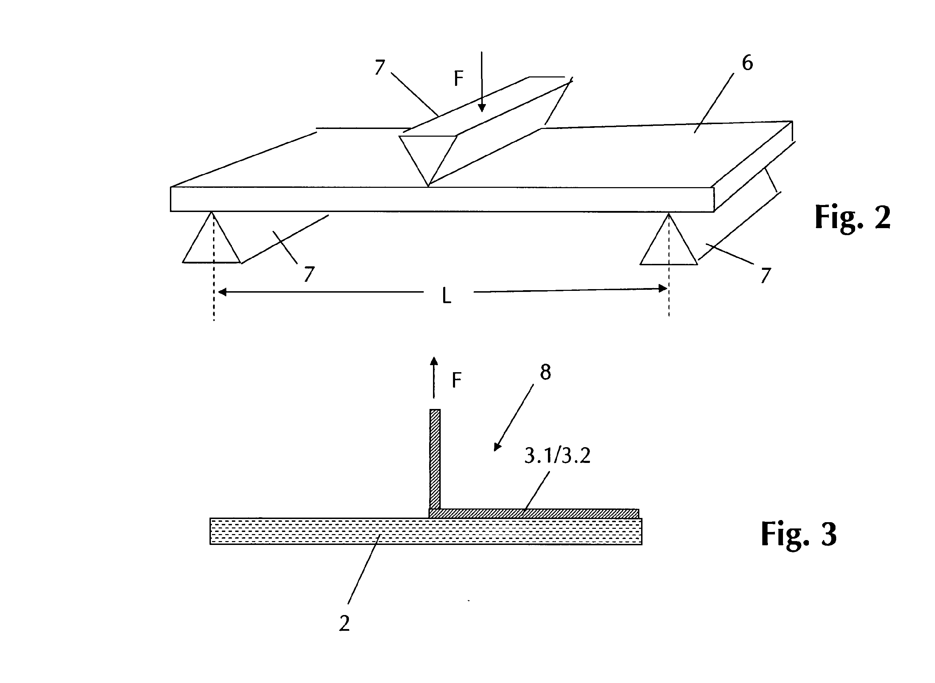

Die Bruchfestigkeit s wird dabei mit dem in der Figur 2 schematisch dargestellten Dreipunktbelastungsverfahren ermittelt. Bei diesem Verfahren wird der in Draufsicht rechteckförmige Prüfling 6, der beispielsweise eine der beiden Keramikschichten 2 oder aber das Metall-Keramik-Substrat 1 selbst ist, beidendig, d.h. in der Nähe seiner Schmalseiten auf Auflagen 7 aufgelegt, die sich jeweils senkrecht zu den Längsseiten des Prüflings 6 erstrecken, parallel und voneinander beabstandet vorgesehen sind. Der Prüfling 6 wird anschließend an seiner Oberseite in der Mitte zwischen den Auflagen 7 über eine weitere Auflage 7 oder einen keilförmigen Stempel mit einer Kraft F belastet wird. Die spezifische Bruchfestigkeit s bestimmt sich dann nach folgender Formel:

$$s = 1,5 \times F \times L / B \times d6.$$

Hierbei sind

F die Kraft in Newton, bei der nach dem zunächst elastischen Verformen des Prüflings 6 ein Bruch dieses Prüflings eintritt;

L der Abstand, den die beiden von den unteren Auflagen 7 bestimmten Auflagebereiche in Längsrichtung des Prüflings 6 aufweisen, in Millimeter;

B die Breite, die der Prüfling 6 senkrecht zu seiner Längserstreckung in Millimeter und

d6 die Dicke des Prüflings 6 in Millimeter.

Die spezifische Bruchfestigkeit s der reinen Keramik ist größer als 400 N/mm$^2$, was auch der spezifischen Bruchfestigkeit eines herkömmlichen Metall-Keramik-Substrates mit nur einer Keramikschicht entspricht, da die beidseitig aufgebrachte Metallschichten nur geringfügig zur Erhöhung der spezifischen Bruchfestigkeit beitragen. Messungen haben bestätigt, dass die spezifische Bruchfestigkeit des Metall-Keramik-Substrates 1 deutlich, d.h. mindestens um den Faktor 1,5 über der spezifischen Bruchfestigkeit eines Metall-Keramik-Substrates mit nur einer Keramikschicht liegt, deren Schichtdicke gleich der Summe der Schichtdicken d2 ist.

Um die erhöhte spezifische Bruchfestigkeit zu erreichen ist es nach einer der Erfindung zugrundeliegenden Erkenntnis erforderlich, zumindest aber zweckmäßig, dass die Verbindung zumindest zwischen der inneren Metallschicht 3.1 und den angrenzenden Keramikschichten 2 mit ausreichend hoher Haft- oder Peelfestigkeit ausgeführt ist. Die Haft-oder Peelfestigkeit wird dabei in der in der Figur 3 dargestellten Weise an einem Prüfling 8 gemessen, der aus einer Keramikschicht 2 und der mit dieser Keramikschicht verbundenen Metallschicht 3.1 besteht, und zwar in der Weise, dass die Metallschicht 3.1 mit einer Kraft F in einer Achsrichtung senkrecht zur Ebene der Oberflächenseite der Keramikschicht 2 abgezogen wird. Die Metallschicht 3.1 ist dabei streifenförmig mit einer Breite von 50 mm und einer Dicke von 0,5 mm ausgebildet. Die Haft- oder Peelfestigkeit ist dabei der Quotient aus der Kraft F (in N),die zum Ablösen der Metallschicht 3.1 von der Keramikschicht 2 mindestens erforderlich ist, und der Breite (in mm) der Metallschicht 3.

Um die vorgenannte Erhöhung der Bruchfestigkeit s1 für das Metall-Keramik-Substrat 1 zu erreichen, ist nach der der Erfindung zugrundeliegenden Erkenntnis eine Haft- oder Peelfestigkeit größer 10 N/mm erforderlich.

Das Metall-Keramik-Substrat 1 besitzt zusätzlich verbesserte thermische Eigenschaften. Diese bestehen zum einen darin, dass das Metall-Keramik-Substrat 1 eine hohe Temperaturwechselbeständigkeit aufweist. Auch bei häufigen und hohen oder extremen Temperaturwechseln der Substrattemperatur ist das Metall-Keramik-Substrat stabil, d.h. es tritt insbesondere keine die Eigenschaften des Metall-Keramik-Substrates 1 und dabei vor allem keine die mechanischen und elektrischen Eigenschaften (insbesondere Spannungsfestigkeit) beeinträchtigende Beschädigungen, z.B. Rissbildungen in den Keramikschichten 2 auf, und zwar trotz der unterschiedlichen thermischen Ausdehnungskoeffizienten von Keramik und Metall bzw. Kupfer. Häufige und extreme Temperaturwechsel im Metall-Keramik-Substrat 1 treten insbesondere dann auf, wenn dieses Substrat beispielsweise als Basis oder Leiterplatte für elektrische Schaltkreise oder Module hoher Leistung, beispielsweise zum Schalten von Antrieben oder anderen Verbrauchern mit hoher Leistung verwendet wird. Um diese Temperaturwechselbeständigkeit zu erreichen, sieht die Erfindung vor, dass die Brinell-Härte des Metalls der Metallschichten 3.1, 4 und 5 bei Verwendung kleiner als 75 und vorzugsweise (insbesondere bei Verwendung von Aluminium) kleiner als 40 ist.

Verbesserte thermische Eigenschaften für das Metall-Keramik-Substrat 1 ergeben sich in überraschender Weise auch dadurch, dass die innere Metallschicht 3 als Wärmespreitzer wirkt. Zum besseren Verständnis anzumerken, dass im Verwendungsfall die obere Metallschicht 4 so strukturiert ist, dass ein Metallschichtbereich dieser Metallschicht eine Kontakt- oder Montagefläche für ein elektrisches oder elektronisches Leistungsbauelement bildet, welches während des Betriebes Verlustwärme abgibt, wie dies in der Figur 1 mit dem Pfeil W angedeutet ist. Diese Verlustwärme W wird durch die obere Keramikschicht 2 in die innere Metallschicht 3.1 weitergeleitet, in der ein seitliches Verteilen, d.h. Spreizen der Verlustwärme erfolgt, wie dies in der Figur 1 mit den Pfeilen W' angedeutet ist. Die Verlustwärme wird somit von der gesamten oder nahezu der gesamten Fläche der Metallschicht 3.1 auf großem Querschnitt durch die untere Keramikschicht 2 an die untere Metallschicht 5 bzw. an einen nicht dargestellten, mit dieser Metallschicht zumindest thermisch verbundenen Kühler weitergeleitet.

Das Metall-Keramik-Substrat 1 besitzt weiterhin verbesserte elektrische Eigenschaften. Erwähnt wurden bereits die Vermeidung von thermisch bedingten Störungen oder Rissen in den Keramikschichten 2 bei Temperaturwechselbelastungen durch entsprechende Wahl der Metallhärte für die Metallschichten 3, 4 und 5 und die Vermeidung einer Reduzierung der Spannungsfestigkeit des Metall-Keramik-Substrates durch derartige Störungen oder Risse.

Es hat sich auch gezeigt, dass die geringe Härte der Metallschichten 3.1, 4 und 5 speziell beim DCB-Bonden , aber auch beim Aktivlöten von großem Vorteil ist, da durch die reduzierte Härte der Metallschichten 3, 4 und 5 beim Abkühlen des Metall-Keramik-Substrates nach dem Bonden von der hohen Prozesstemperatur (etwa 1025°C bis 1083°C; etwa 800°C - 1000°C beim Aktivlöten) auf Umgebungstemperatur thermisch bedingte und die elektrische Spannungsfestigkeit des Metall-Keramik-Substrates beeinträchtigende Risse in den Keramikschichten 2 nicht auftreten.

Weiterhin hat sich in überraschender Weise gezeigt, dass durch den Aufbau des Metall-Keramik-Substrates 1 die Spannungsfestigkeit dieses Substrates wesentlich erhöht werden kann, und zwar auf einem Wert, der wesentlich größer ist als die Spannungsfestigkeit, die eine Keramikschicht mit einer Schichtdicke aufweist, die gleich der Summe der schichtdicken d2 ist.

Unter Spannungsfestigkeit ist dabei bei einer äußeren, an den Metallschichten 4 und 5 anliegenden elektrischen Gleichspannung diejenige in den Keramikschichten 2 vorhandene elektrische Feldstärke zu verstehen, bei der gerade noch kein elektrischer Durchschlag erfolgt, d.h. insbesondere die Teilentladung noch unter einem vorgegebenen Schwellwert liegt. Bei einer einzelnen Keramikschicht mit einer Schichtdicke von etwa 0,64 mm ist diese die Spannungs- oder Durchschlagfestigkeit bestimmende Feldstärke mindestens 10 kV/mm. Bei Verwendung von zwei Keramikschichten 2 mit jeweils einer Schichtdicke von 0,32 mm in dem Metall-Keramik-Substrat 1 liegt die die Spannungsfestigkeit bzw. Durchschlagfestigkeit bestimmende Feldstärke mindestens

18 kV/mm. Dies bedeutet, dass die Spannungsfestigkeit des Metall-Keramik-Substrates 1 ist bei gleicher Gesamtdicke der Keramikschichten 2 mindestens um den Faktor 1,4 höher ist als bei einem Metall-Keramik-Substrat mit nur einer Keramikschicht, die die zweifache Schichtdicke d2 der Keramikschicht 2 aufweist.

Die Erhöhung der Bruchfestigkeit des Metall-Keramik-Substrates 1 im Vergleich zu einem Metall-Keramik-Substrat, welches nur eine einzige Keramikschicht, allerdings mit der zweifachen Dicke d2 aufweist, ist auf die mittlere, die beiden Keramikschichten 2 voneinander beanstandende Zwischenschicht 3 zurückzuführen. Die Schichtdicke dieser Zwischenschicht ist so gewählt, dass sich für das Metall-Keramik-Substrat 1 diese wenigstens um den Faktor 1,5 erhöhte Bruchfestigkeit ergibt.

Die Figur 4 zeigt als weitere Ausführungsform ein Metall-Keramik-Substrat 1a, welches sich von dem Metall-Keramik-Substrat 1 der Figur 1 im Wesentlichen dadurch unterscheidet, dass die der Zwischenschicht 3 entsprechende mittlere Zwischenschicht 3a mehrschichtig ausgeführt ist, und zwar bestehend aus der Metallschicht 3.1 und einer weiteren Metallschicht 3.2. Die beiden Metallschichten 3.1 und 3.2, von denen die Metallschicht 3.1 mit der Unterseite der in der Figur 4 oberen Keramikschicht 2 und die Metallschicht 3.2 mit der Oberseite der in der Figur 4 unteren Keramikschicht 2 verbunden ist, und zwar jeweils durch DCB-Bonden oder Aktivlöten, sind über eine Verbindungsschicht 9 flächig miteinander verbunden sind. Die Verbindungsschicht 9 ist dabei beispielsweise von einem Hartlot gebildet, beispielsweise von einem Hartlot dessen Schmelzpunkt höher 300°C ist. Die beiden Metallschichten 3.1 und 3.2 besitzen beispielsweise beide jeweils die Schichtdicke d3, sodass die beiden Keramikschichten 2 des Metall-Keramik-Substrates 1a noch weiter voneinander beabstandet sind als beim Metall-Keramik-Substrat 1. Hierdurch weist das Metall-Keramik-Substrat 1a eine Vergleich zum Metall-Keramik-Substrat 1 noch höhere Biegesteifigkeit und Bruchfestigkeit auf. Außerdem ist durch die im Vergleich zur Zwischenschicht 3 größere Schichtdicke der mehrlagigen Zwischenschicht 3a der Wärmespreizeffekt verbessert.

Die Herstellung des Metall-Keramik-Substrates 1a erfolgt bevorzugt in der Weise, dass die beiden Keramikschichten 2 jeweils beidseitig mit der Metallisierung 3.1 und 4 bzw. 3.2 und 5 versehen werden, beispielsweise unter Verwendung des DCB-Verfahrens und/oder des Aktivlöt-Verfahrens (Aktivlöten) und dass dann die so hergestellten Teilsubstrate über die Verbindungsschicht 9 an den Metallschichten 3.1 und 3.2 mit einander verbunden werden.

Die Figur 5 zeigt als weitere Ausführungsform ein Metall-Keramik-Substrat 1 b, welches sich von dem Metall-Keramik-Substrat 1a im Wesentlichen nur dadurch unterscheidet, dass die beiden Metallschichten 3.1 und 3.2, die die mehrlagige die beiden Keramikschichten 2 voneinander beabstandende Zwischenschicht 3b bilden, durch DCB-Bonden miteinander verbunden sind, sodass die Verbindungsschicht 9 entfallen ist.

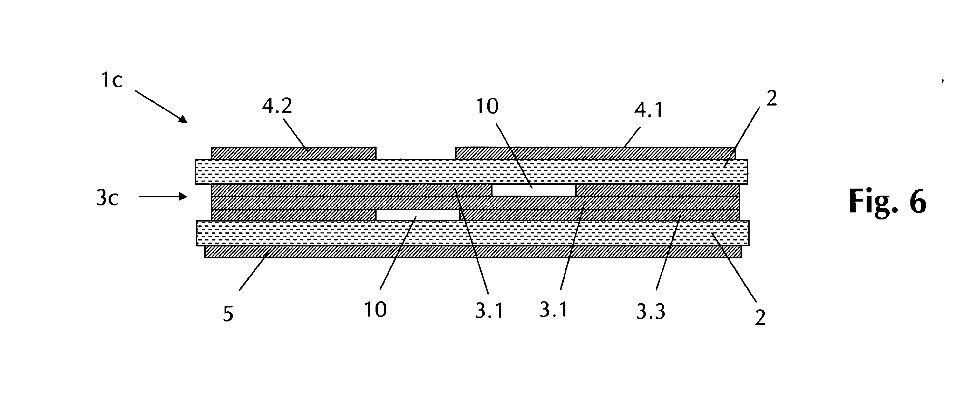

Die Figur 6 zeigt als weitere Ausführungsform ein Metall-Keramik-Substrat 1c, welches sich von dem Metall-Keramik-Substrat 1b zunächst dadurch unterscheidet, dass die mittlere, die beiden Keramikschichten 2 voneinander beabstandende Metallschicht 3c dreilagig ausgeführt ist, und zwar bestehend aus den Metallschichten 3.1, 3.2 und 3.3, die wiederum durch DCB-Bonden, Aktivlöten und/oder Hartlöten miteinander verbunden sind und von denen die Metallschicht 3.1 mit der Unterseite der in der Figur 6 oberen Keramikschicht 2 und die Metallschicht 3.2 mit der in der Figur 6 oberen Seite der unteren Keramikschicht 2 verbunden sind, und zwar jeweils durch DCB-Bonden oder Aktivlöten.

Wie in der Figur 6 dargestellt, sind die Metallschichten 3.1 und 3.2 strukturiert, sodass innerhalb dieser Metallschichten Kammern oder Kanäle bzw. Ausnehmungen 10 gebildet sind, und zwar zur Aufnahme von beim Verbinden oder Bonden freigesetzten gas- und/oder dampfförmigen und/oder flüssigen Bestandteilen, beispielsweise auch zur Aufnahme von überschüssigen Verbindungs- oder Bondmaterial, z.B. Lot.

Um die mechanischen sowie thermischen Eigenschaften des Metall-Keramik-Substrates 1c nicht zu beeinträchtigen, d.h. um die angestrebte hohe Bruchfestigkeit und den angestrebten geringen Wärmewiderstand zwischen Oberseite und der Unterseite des Metall-Keramik-Substrates 1c nicht zu beeinträchtigen, sind die Ausnehmungen 10 in den Metallschichten 3.1 und 3.2 gegeneinander versetzt vorgesehen, d.h. so angeordnet, dass sie sich nicht überlappen.

Die Metallschicht 3.3 ist durchgängig, d.h. ohne Ausnehmungen 10 dargestellt. Selbstverständlich können auch in dieser Schicht entsprechende Ausnehmungen ausgebildet sein. Die obere Metallschicht 4 ist bei dieser Ausführungsform strukturiert, und zwar zur Bildung von elektrisch voneinander getrennten Metallschichtbereichen 4.1 und 4.2.

Die Herstellung des Metall-Keramik-Substrates 1c erfolgt beispielsweise so, dass zunächst die Keramikschichten 2 jeweils an ihren Oberflächenseiten mit den Metallschichten 3.1 und 4 bzw. 3.2 und 5 versehen sind, beispielsweise durch DCB-Bonden oder Aktivlöten, und dass dann die so erhaltenen Teilsubstrate mit ihren Metallschichten 3.1 und 3.2 über die Metallschicht 3.3 miteinander verbunden werden, beispielsweise unter Verwendung eines geeigneten Bondmittels, z.B. Hartlot. Auch andere Bond-Verfahren, beispielsweise DCB-Bonden und/oder Aktivlöten sind für das Verbinden der Metallschichten 3.1 und 3.2 mit der Metallschicht 3.3 möglich.

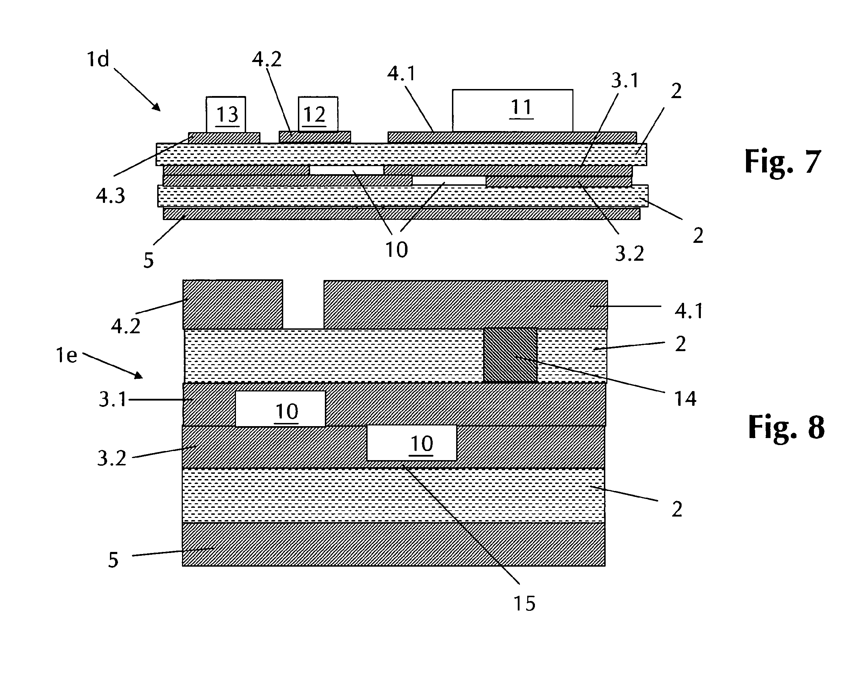

Die Figur 7 zeigt als weitere Ausführungsform ein Metall-Keramik-Substrat 1d, bei dem die die beiden Keramikschichten 2 voneinander beabstandende mittlere Zwischenschicht 3d wiederum von den beiden, flächig miteinander verbundenen Metallschichten 3.1 und 3.2 gebildet ist. An den der Zwischenschicht 3d abgewandten Oberflächenseite sind die Keramikschichten 2 mit der Metallschicht 4 bzw. 5 versehen. Insoweit entspricht das Metall-Keramik-Substrat 1d dem Metall-Keramik-Substrat 1b. Allerdings sind bei dem Metall-Keramik-Substrat 1d die Metallschichten 3.1 und 3.2 wiederum zur Bildung der Ausnehmungen 10 strukturiert, die zur Aufnahme von beim Bonden entsprechenden gas- und/oder dampfförmigen und/oder beim Bonden anfallenden flüssigen Bestandteilen, beispielsweise auch zur Aufnahme von überflüssigem Bondmittel dienen. Weiterhin ist die Metallschicht 4 an der Oberseite des Metall-Keramik-Substrates 1d zur Ausbildung von elektrisch voneinander getrennten Metallschichtbereichen 4.1, 4.2 und 4.3 strukturiert, wobei der Metallschichtbereich 4.1 als Montagefläche für ein elektrisches oder elektronisches Leistungsbauelement oder Modul 11 dient, welches beispielsweise ein IGBT (Insulated-Gate-Bipolar-Transistor) ist und zumindest thermisch mit dem Metallschichtbereich 4.1 verbunden ist. Auf dem Metallschichtbereich 4.2 und 4.3 sind weitere elektrische oder elektronische Bauteile 12 und 13 vorgesehen, die ebenfalls wiederum zumindest thermisch, vorzugsweise aber auch elektrisch mit diesen Metallschichtbereichen verbunden sind. Die Bauteile 12 und 13 sind beispielsweise Ansteuer-oder Treiberschaltkreise- oder -Module, Dioden, Widerstände usw.

Die Figur 8 zeigt in vergrößerter Teildarstellung einen Schnitt durch ein Metall-Keramik-Substrat 1e, welches im Wesentlichen identisch mit dem Metall-Keramik-Substrat 1d ausgeführt ist, allerdings zunächst mit dem Unterschied, dass der Metallschichtbereich 4.1 an der Oberseite des Substrates über eine Öffnung in der oberen Keramikschicht 2 und über eine in dieser Öffnung ausgebildete Durchkontaktierung 14 mechanisch, thermisch und elektrisch mit der Metallschicht 3.1 und über diese auch mit der Metallschicht 3.2 verbunden ist. Die Durchkontaktierung 14 besteht aus einem metallischen Material, welches bevorzugt das Material zumindest der Metallschichten 3.1 und 4, vorzugsweise aber das Material sämtlicher Metallschichten 3.1, 3.2, 4 und 5 ist.

Wie die Figur 8 weiterhin zeigt, sind die beiden Metallschichten 3.1 und 3.2 zur Ausbildung der Ausnehmungen 10 so ausgeführt, dass diese zwar bis an die Verbindungsebene zwischen den Metallschichten 3.1 und 3.2 reichen, nicht aber bis unmittelbar an die jeweils benachbarte Keramikschicht 2, d.h. jede Ausnehmung 10 weist einen Boden 15 auf, der von einem in der Dicke stark reduzierten Bereich der zugehörigen Metallschicht 3.1 bzw. 3.2 gebildet ist und der somit den Innenraum der betreffenden Ausnehmung 10 von der benachbarten Keramikschicht 2 trennt. Bevorzugt sind auch andere Metall-Keramik-Substrate hinsichtlich der Kanäle oder Kammern bzw. Ausnehmungen 10 in dieser Weise ausgeführt, beispielsweise auch die Metall-Keramik-Substrate 1c und 1d.

Die Herstellung des Metall-Keramik-Substrat 1e erfolgt vorzugsweise wiederum in der Form, dass zunächst die beiden Teilsubstrate bestehend aus jeweils einer Keramikschicht 2 und den Metallschichten 3.1 und 4 bzw. 3.2 und 5 gefertigt werden, und zwar mit der wenigstens einen Durchkontaktierung 14, dass dann die Strukturierung der Metallschichten 3.1 und 3.2 zur Bildung der Kanäle bzw. Kammern 10 sowie das Strukturieren zumindest der Metallschicht 4 zur Ausbildung der Metallschichtbereiche 4.1, 4.2, 4.3 usw. erfolgt, und zwar mit einer geeigneten Technik, z.B. Ätz- und Maskierungstechnik und/oder durch mechanische Bearbeitung. Die so hergestellten Teilsubstrate werden anschließend an den Metallschichten 3.1 und 3.2 miteinander verbunden, beispielsweise durch DCB-Bonden, Aktivlöten oder Hartlöten oder unter Verwendung eines anderen, geeigneten Bondmittels. Die Ausnehmungen 10 sind dabei an derjenigen Oberflächenseite der Teilsubstrate offen, an der das Verbinden dieser Teilsubstrate zu dem Metall-Keramik-Substrat 1e erfolgt.

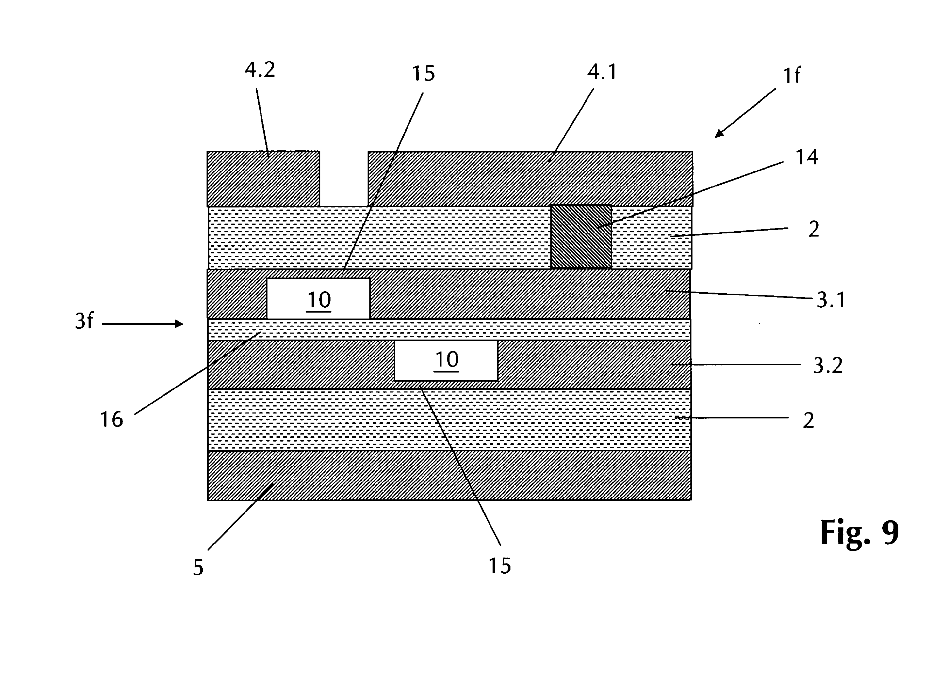

Die Figur 9 zeigt als weitere Ausführungsform ein Metall-Keramik-Substrat 1f, welches sich von dem Metall-Keramik-Substrat 1e lediglich dadurch unterscheidet, dass die mittlere, die beiden Keramikschichten 2 voneinander beabstandende mehrlagige Zwischenschicht 3f zusätzlich zu den beiden Metallschichten 3.1 und 3.2 eine zwischen diesen Metallschichten angeordnete, bei der dargestellten Ausführungsform dünne Isolierschicht 16 aufweist. Die Isolierschicht 16 ist beispielsweise wiederum eine Keramikschicht. An die Isolierschicht 16 grenzen bei der dargestellten Ausführungsform die Ausnehmungen 10 unmittelbar an.

Die Herstellung des Metall-Keramik-Substrates 1f erfolgt in analoger Weise zur Herstellung des Metall-Keramik-Substrates 1e, und zwar wiederum in der Form, dass zunächst die beiden Teilsubstrate aus der Keramikschicht 2 und den Metallschichten 3.1 und 4 bzw. 3.2 und 5 mit den Durchkontaktierungen 14 gefertigt und dann zur Ausbildung der Ausnehmungen 10 sowie der Metallschichtbereiche 4.1, 4.2, 4.3 usw. strukturiert werden, und zwar mit einer geeigneten Technik, z.B. Ätz- und Maskierungstechnik und/oder durch mechanische Bearbeitung. Im Anschluss daran erfolgt das Verbinden der Teilsubstrate mit ihren Teilschichten 3.1 und 3.2 über die Isolierschicht 16 unter Verwendung eines geeigneten Bond-Verfahrens, beispielsweise durch DCB-Bonden, Aktivlöten. Die Ausnehmungen 10 sind dabei wiederum an derjenigen Oberflächenseite der Teilsubstrate offen, an der das Verbinden dieser Teilsubstrate über die Isolierschicht 16 zu dem Metall-Keramik-Substrat 1f erfolgt.

Während die Zwischenschichten 3, 3a - 3d bei den Metall-Keramik-Substraten 1, 1a - 1d lediglich zur Beabstandung der beiden Keramikschichten 2 dienen, haben die Zwischenschichten 3e und 3f durch die wenigstens eine Durchkontaktierung 14 auch elektrische Funktion, d.h. die Zwischenschicht 3e bzw. die Metallschicht 3.1 der Zwischenschicht 3f dienen beispielsweise als Anschluss oder elektrische Verbindung.

Die Keramik der Keramikschichten 2 der Metall-Keramik-Substrate 1a - 1f ist wiederum bevorzugt 203, als 203 - ZrO2AlN oder Si3N4 und besitzen beispielsweise eine Schichtdicke d2 im Bereich zwischen etwa 0,2 mm bis 1,3 mm. Die Metallschichten 3.1, 3.2, 3.3, 4 und 5 sind beispielsweise solche aus Kupfer oder einer Kupferlegierung. Auch andere metallische Materialien sind für diese Metallschichten grundsätzlich möglich, bevorzugt auch Aluminium oder Aluminiumlegierungen. Die Schichtdicken d3.1 und d3.2 der Metallschichten 3.1 und 3.2 liegen beispielsweise im Bereich zwischen 0,1 mm bis 0,8 mm, ebenso beispielsweise die Schichtdicke d3.3 der Metallschicht 3.3 und/oder die Schichtdicken d4 und d5 der äußeren Metallschichten 3 und 4.

Die Gesamtdicke der die beiden Keramikschichten 2 voneinander beabstandende Zwischenschicht 3a - 3f ist bei den Metall-Keramik-Substraten 1a - 1f so gewählt, dass das jeweilige Metall-Keramik-Substrat 1a - 1f die erforderliche Biegesteifigkeit sowie eine Bruchfestigkeit aufweist, die deutlich größer ist als die Bruchfestigkeit einer einzelnen Keramikschicht, deren Schichtdicke gleich der Summe der Schichtdicken d2 der beiden Keramikschichten 2 ist, und zwar mindestens um den Faktor 1,5. Weiterhin beträgt die Haft-oder Peelfestigkeit der Verbindung zumindest zwischen der jeweiligen Keramikschicht 2 und der benachbarten Metallschicht 3.1 bzw. 3.2 bei den Metall-Keramik-Substrat 1a-1f ebenfalls wenigstens 10N/mm, und zwar bei reduzierter Metallhärte zumindest der Metallschichten 3.1 und 3.2, bevorzugt auch der Metallschichten 3.3, 4 und 5, d.h. bei einer Brinell-Härte kleiner als 75, vorzugsweise kleiner als 40.

Die Metall-Keramik-Substrate 1a - 1f besitzen die selben verbesserten mechanischen, thermischen und elektrischen Eigenschaften, wie sie für das Metall-Keramik-Substrat 1 angegeben wurden, d.h. eine hohe Biegesteifigkeit und Bruchfestigkeit, eine hohe Wärmespreizwirkung in der Zwischenschicht 3a - 3f, eine hohe Temperaturwechselbeständigkeit (auch gefördert durch die reduzierte Metallhärte der Metallschichten) sowie verbesserte elektrische Eigenschaften, insbesondere hinsichtlich der Spannungs- und Durchschlagfestigkeit. Diese ist wiederum mindestens um den Faktor 1,4 besser ist als bei einem Metall-Keramik-Substrat mit einer einzigen Keramikschicht, deren Schichtdicke der Summe der Schichtdicken d2 der Keramikschichten 2 entspricht.

Bei den Metall-Keramik-Substraten 1a - 1f bilden die Metallschichten 4 und 5 wiederum mit ihren der jeweils benachbarten Keramikschicht 2 abgewandten Oberflächenseiten die Oberseite (Metallschicht 4) bzw. die Unterseite (Metallschicht 5) des Metall-Keramik-Substrates 1.

Auch die Metall-Keramik-Substrate 1a - 1f sind bevorzugt zumindest in thermischer Hinsicht spiegelsymmetrisch oder im Wesentlichen spiegelsymmetrisch zu der in der Mitte zwischen der Substratoberseite und der Substratunterseite verlaufenden und parallel zu diesen Seiten verlaufenden Substratmittelebene ausgebildet, sodass bei Temperaturänderungen ein das Substrat wölbender BI-Metall-Effekt nicht eintritt. Bevorzugt sind die Metall-Keramik-Substrate 1a - 1f ebenfalls hinsichtlich der Schichtfolge, d.h. hinsichtlich Anzahl und Art der Schichten, hinsichtlich der Schichtdicken und hinsichtlich der für die Schichten verwendeten Materialien spiegelsymmetrisch oder im Wesentlichen spiegelsymmetrisch zu der Substratmittelebene ausgebildet.

Die Erfindung wurde voranstehend an Ausführungsbeispielen beschrieben. Es versteht sich, dass zahlreiche Änderungen sowie Abwandlungen möglich sind, ohne dass dadurch der der Erfindung zugrundeliegende Erfindungsgedanke verlassen wird.

So wurde vorstehend davon ausgegangen, dass das Verbinden oder Bonden der verschiedenen Metallschichten 3.1, 3.2, 3.3, 4, 5 untereinander bzw. mit den angrenzenden Keramikschichten 2 durch DCB-Bonden, Aktivlöten und/oder Hartlöten erfolgt. Grundsätzlich können auch Klebeverbindungen oder Klebe-Techniken unter Verwendung von Kunststoff-Klebern, beispielsweise unter Verwendung von Klebern auf Epoxyharz-Basis für das Bonden verwendet werden, und zwar insbesondere auch faserverstärkte Kleber, die dann beispielsweise durch ihren Faseranteil die thermisch Ausdehnung benachbarter Metallschichten reduzieren und damit u.a. die Temperaturwechselbeständigkeit noch weiter verbessern.

Geeignet sind dabei speziell Kleber, die Carbon-Fasern und/oder Carbon-Nanofasern und/oder Carbon-Nanotubes enthalten, und/oder Kleber, mit denen eine thermische und/oder elektrisch gut leitende Klebeverbindung möglich ist.

Für den Kleber wird bevorzugt ein Kunststoffmaterial (z.B. Epoyharz)verwendet, welches bei der üblichen, beim Bonden von Bauelementen auf Substraten oder Leiterplatten verwendeten Löttemperatur, beispielsweise von 350°C wenigstens über 5 Minuten stabil ist. Da aber beim Löten die jeweilige Löttemperatur nur kurzzeitig zur Anwendung kommt, ist grundsätzlich eine Temperaturfestigkeit des als Bondmaterial verwendeten Klebers kleiner als die Löttemperatur, beispielsweise kleiner als 350°C ausreichend, beispielsweise eine Temperaturfestigkeit von wenigstens 220°C.

Bei den vorstehend beschriebenen Metall-Keramik-Substraten 1a - 1f ist die jeweilige Zwischenschicht 3, 3a - 3f durchgängig ausgeführt. Auch wenn dies die bevorzugte Ausführungsform ist, sind auch Ausführungsformen denkbar, bei denen die die Keramikschichten beabstandende Zwischenschicht aus mehreren Bereichen oder Abschnitten besteht.

## Bezugszeichenliste

| | |
|---|---|
| 1, 1a - 1f | Metall-Keramik-Substrat |
| 2 | Keramikschicht |
| 3, 3a - 3f | Zwischenschicht zur Beabstandung der Keramikschichten 2 |
| 3.1 - 3.3 | Metallschicht |
| 4, 5 | Metallschicht |
| 4.1 - 4.3 | Metallschichtbereich |
| 6 | Prüfling |
| 7 | Auflage |
| 8 | Prüfling |
| 9 | Verbindungs- oder Bondschicht |
| 10 | Ausnehmungen |
| 11 | elektrisches oder elektronisches Leistungsbauteil oder -modul |
| 12, 13 | elektrisches oder elektronisches Bauteil |
| 14 | Durchkontaktierung |
| 15 | Boden |
| 16 | Isolierschicht |
| F | auf den Prüfling 6 bzw. 8 ausgeübte Kraft |
| W | in das Metall-Keramik-Substrat eingebrachte Wärmeenergie |
| W' | Wärmespreizung |
| L | Abstand zwischen den Auflageflächen |
| B | Breite des Prüflings 6 |
| M | Substratmittelebene |

## Patentansprüche

1. Metall-Keramik-Substrat, insbesondere Substrat für elektrische Schaltkreise oder Module, mit wenigstens einer ersten eine erste Oberflächenseite des Metall-Keramik-Substrates (1, 1a - 1f) bildenden äußeren Metallschicht (4) und mit wenigstens einer zweiten eine zweite Oberflächenseite des Metall-Keramik-Substrates (1, 1a - 1f) bildenden äußeren Metallschicht (5), wobei die äußeren Metallschichten (4, 5) jeweils durch Bonden flächig mit den Oberflächenseiten eines plattenförmigen Substratkörpers verbunden sind, **dadurch gekennzeichnet, dass** zur Erzielung verbesserter mechanischer, thermischer und elektrischer Eigenschaften der Substratkörper aus wenigstens zwei Keramikschichten (2) und aus wenigstens einer zwischen diesen Keramikschichten (2) angeordneten, die Keramikschichten (2) voneinander beabstandende Zwischenschicht (3, 3a - 3f) besteht, die von wenigstens einer inneren Metallschicht (3.1, 3.3) gebildet und durch Bonden flächig mit den Keramikschichten (2) verbunden ist.

2. Metall-Keramik-Substrat nach Anspruch 1, **gekennzeichnet durch** eine einzige Zwischenschicht (3, 3a - 3f) zwischen den wenigstens zwei Keramikschichten (2), wobei sich die Zwischenschicht (3, 3a - 3f) über die gesamte oder im Wesentlichen über die gesamte der Zwischenschicht benachbarte Oberflächenseite der Keramikschichten (2) erstreckt.

3. Metall-Keramik-Substrat nach Anspruch 1 oder 2, **dadurch gekennzeichnet, dass** die Schichtdicke (d3, d3a - d3f) der Zwischenschicht (3, 3a - 3f) wenigstens gleich der Schichtdicke (d4, d5) der äußeren Metallschichten (4, 5) ist, bevorzugt aber größer ist als die Schichtdicke (d4, d5) der äußeren Metallschicht en(4, 5) und/oder größer ist als die Schichtdicke (d2) wenigstens einer der Keramikschichten (2).

4. Metall-Keramik-Substrat nach einem der vorhergehenden Ansprüche, **dadurch gekennzeichnet, dass** die Zwischenschicht (3a - 3f) mehrlagig mit wenigstens zwei inneren Metallschichten (3.1 - 3.3) und/oder mit wenigstens einer inneren Metallschicht (3.1, 3.2) und einer inneren Isolierschicht (16), beispielsweise mit einer inneren Keramikschicht ausgebildet ist, und dass die die mehrlagige Zwischenschicht (3a - 3f) bildenden inneren Schichten (3.1 - 3.3, 16) durch Bonden flächig miteinander verbunden sind.

5. Metall-Keramik-Substrate nach Anspruch 1 oder 2, **dadurch gekennzeichnet, dass** die Zwischenschicht (3f) mit einer inneren, zwischen zwei inneren Metallschichten (3.1, 3.2) angeordneten Isolierschicht (16) ausgebildet ist.

6. Metall-Keramik-Substrat nach einem der vorhergehenden Ansprüche, **dadurch gekennzeichnet, dass** die Zwischenschicht (3c - 3f) mit wenigstens einer Ausnehmung (10), vorzugsweise mit wenigstens einer Ausnehmung zur Bildung eines Kanals oder einer Kammer zur Aufnahme von beim Bonden freigesetzten gas- und/oder dampfförmigen und/oder flüssigen Bestandteile, insbesondere auch zur Aufnahme von überschüssigem beim Bonden verwendeten Bondmittel ausgebildet ist, wobei die wenigstens eine Ausnehmung vorzugsweise an wenigstens einer Umfangsseite des Metall-Keramik-Substrates (1c - 1f) offen ist.

7. Metall-Keramik-Substrat nach Anspruch 6, **dadurch gekennzeichnet, dass** die mehrlagige Zwischenschicht (3c - 3f) wenigstens zwei innere Metallschichten (3.1, 3.2) aufweist, dass in wenigstens einer dieser Metallschichten (3.1, 3.2) die wenigstens eine Ausnehmung (10) vorgesehen ist wobei beispielsweise die wenigstens eine Ausnehmung (10) bzw. deren Innenraum an einer Seite der wenigstens einen inneren Metallschicht (3.1, 3.2) offen ist, an der diese innere Metallschicht (3.1, 3.2) flächig mit einer weiteren Schicht (3.2, 3.1, 16) zu der mehrlagigen Zwischenschicht (3c - 3f) verbunden ist, und/oder wobei beispielsweise die wenigstens eine Ausnehmung (10) bzw. deren Innenraum von der angrenzenden Keramikschicht (2) durch einen aus der inneren Metallschicht (3.1, 3.2) gebildeten Boden (15) getrennt ist.

8. Metall-Keramik-Substrat nach einem der vorhergehenden Ansprüche, **dadurch gekennzeichnet, dass** es eine Bruchfestigkeit aufweist, die größer ist als die Bruchfestigkeit einer einzelnen Keramikschicht, deren Schichtdicke gleich der Summe der Schichtdicken (d2) der beiden durch die Zwischenschicht (3, 3a - 3f) voneinander beabstandeten Keramikschicht (2) ist, und/oder dass es eine Spannungs- oder Durchschlagfestigkeit von wenigstens 18 kV/mm aufweist.

9. Metall-Keramik-Substrat, **dadurch gekennzeichnet, dass** zumindest die die Zwischenschicht (3, 3a - 3f) bildenden Metallschichten (3.1 - 3.3) oder deren Material eine Brinell-Härte kleiner 75, vorzugsweise kleiner 40 aufweist.

10. Metall-Keramik-Substrat nach einem der vorhergehenden Ansprüche, **dadurch gekennzeichnet, dass** zumindest die die Zwischenschicht (3, 3a - 3f) bildenden inneren Metallschichten (3.1, 3.2) mit einer Haft- oder Peelfestigkeit größer 10N/mm mit der jeweils angrenzenden Keramikschicht (2) verbunden sind.

11. Metall-Keramik-Substrat nach einem der vorhergehenden Ansprüche, **dadurch gekennzeichnet, dass** in wenigstens einer der voneinander beabstandeten Keramikschichten (2) zumindest eine Durchkontaktierung (14) vorgesehen ist, die die auf dieser Keramikschicht (2) angeordnete äußere Metallschicht (4) oder einen Metallschichtbereich (4.1) dieser äußeren Metallschicht (4) mechanisch, thermisch und/oder elektrisch mit einer inneren Metallschicht (3.1) verbindet.

12. Metall-Keramik-Substrat nach einem der vorhergehenden Ansprüche, **dadurch gekennzeichnet, dass** die Keramikschichten (2, 16) solche aus Al203, Al203 - ZrO2, AlN, Si3N4 oder aus einer Kombination dieser Keramiken sind.

13. Metall-Keramik-Substrat nach einem der vorhergehenden Ansprüche, **dadurch gekennzeichnet, dass** die Verbindung zwischen den aneinander angrenzenden Schichten (2, 3.1 - 3.3, 4, 5, 16) durch DCB-Bonden und/oder Aktivlöten und/oder Hartlöten und/oder unter Verwendung eines Klebers, beispielsweise eines Klebers auf Kunststoff- oder Epoxyharz-Basis, z.B. mit Fasern und/oder unter Verwendung eines elektrisch leitenden Klebers hergestellt ist.

14. Verfahren zum Herstellen eines Metall-Keramik-Substrates mit auf einem plattenförmigen Substratkörper vorgesehenen äußeren Metallschicht (4, 5), **dadurch gekennzeichnet, dass** zur Herstellung eines Metall-Keramik-Substrates (1, 1a - 1f) mit verbesserten mechanischen, thermischen und elektrischen Eigenschaften wenigstens zwei Keramikschichten (2) an beiden Oberflächenseiten mit einer Metallschicht (3.1, 4; 3.2, 5) versehen werden, beispielsweise durch DCB-Bonden oder Aktivlöten, und dass die so hergestellten Teilsubstrate an jeweils einer Metallschicht (3.1, 3.2) flächig miteinander verbunden werden, beispielsweise durch Hartlöten, durch Aktivlöten, durch DCB-Bonden und/oder Kleben.

**15.** Verfahren nach Anspruch 14, **dadurch gekennzeichnet, dass** die Metallschichten (3.1, 3.2, 4) der Teilsubstrate vor dem Verbinden dieser Teilsubstrate strukturiert werden, beispielsweise zur Bildung von Metallschichtbereichen (4.1 - 4.3) an einer außenliegenden Seite des Metall-Keramik-Substrats (1c - 1f) und/oder zur Bildung von Ausnehmungen (10) in der die Keramikschichten (2) beabstandenden Zwischenschicht (3c - 3f) oder in einer dortigen Metallschicht (3.1, 3.2).

Fig. 1

Fig. 4

Fig. 5

**Fig. 2**

**Fig. 3**

Fig. 6

EP 2 447 235 A1

**Fig. 7**

1d

4.2

4.1

3.1

2

13

12

11

4.3

10

10

3.2

2

5

**Fig. 8**

4.2

4.1

1e

2

14

3.1

10

3.2

10

2

5

15

**Fig. 9**

Europäisches
Patentamt
European
Patent Office
Office européen
des brevets

**EUROPÄISCHER RECHERCHENBERICHT**

Nummer der Anmeldung

EP 11 00 8249

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | DE 10 2004 033933 A1 (SCHULZ-HARDER JUERGEN [DE] ELECTROVAC AG [AT]) 9. Februar 2006 (2006-02-09) * Absätze [0002], [0044] - [0055]; Ansprüche 12,13; Abbildungen 8,10; Beispiele 5,6 * ----- | 1-15 | INV. C04B37/00 C04B37/02 C04B41/51 H05K3/38 H01L23/373 |
|  |  |  | RECHERCHIERTE SACHGEBIETE (IPC) |
|  |  |  | C04B H05K H01L |

Der vorliegende Recherchenbericht wurde für alle Patentansprüche erstellt

| Recherchenort | Abschlußdatum der Recherche | Prüfer |
|---|---|---|
| München | 9. Februar 2012 | Bonneau, Sébastien |

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**

EP 11 00 8249

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

09-02-2012

| Im Recherchenbericht angeführtes Patentdokument | Datum der Veröffentlichung | Mitglied(er) der Patentfamilie | Datum der Veröffentlichung |
|---|---|---|---|
| DE 102004033933 A1 | 09-02-2006 | AT 480985 T<br>DE 102004033933 A1<br>EP 1774841 A1<br>JP 4764877 B2<br>JP 2008505503 A<br>US 2009232972 A1<br>WO 2006005281 A1 | 15-09-2010<br>09-02-2006<br>18-04-2007<br>07-09-2011<br>21-02-2008<br>17-09-2009<br>19-01-2006 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US PS3744120 A
- DE PS2319854 C
- DE 2213115
- EP 153618 A